# EUROPÄISCHE PATENTANMELDUNG

(11) **EP 0 523 033 A1**
(43) Veröffentlichungstag der Anmeldung: **13.01.1993**
(21) Anmeldenummer: 92890165.1
(22) Anmeldetag: 09.07.1992
(51) Int. Cl.: H01J 37/30

(54) **Ionenoptisches Abbildungssystem**

(30) Priorität: 10.07.1991 AT 1388/91
(71) Anmelder: IMS Ionen Mikrofabrikations Systeme Gesellschaft m.b.H., A-1020 Wien (AT)
(72) Erfinder: Stengl, Gerhard, Dr., A-9241 Wernberg, Kärnten (AT); Chalupka, Alfred, Dr., A-1170 Wien (AT)
(74) Vertreter: Matschnig, Franz, Dipl.-Ing.

(57) **Zusammenfassung**

Die Erfindung betrifft ein ionenoptisches Abbildungssystem, in dem eine auf einer Maske M befindliche Struktur in Gestalt einer oder mehrerer Öffnungen über ein Linsensystem auf einen Wafer (W) abgebildet wird, mit einer zwischen der Maske und denn Wafer angeordneten Kombinaion aus zwei Sammellinsen L1,L2, wobei die Maske jeweils annähernd in der gegenstandsseitigen Brennebene der auf die Maske folgenden Sammellinse und der Wafer in der Umgebung der bildseitigen Brennebene der auf die Maske folgenden zweiten Sammellinse positioniert ist und bevorzugt die gegenstandsseitige Brennebene der zweiten auf die Maske folgenden Sammellinse den Crossover der ersten auf die Maske folgenden Sammellinse enthält, wobei die Kombination aus zwei Sammellinsen von folgenden Linsenarten gebildet wird:
a) von zwei beschleunigenden EINZEL-Linsen,
b) von einer beschleunigenden und einer verzögernden Immersionslinse, wobei die beschleunigende Immersionslinse auf die Maske folgt, oder
c) von einer beschleunigenden Immersionslinse und einer asymmetrischen verzögernden EINZEL-Linse, wobei die beschleunigende Immersionslinse auf die Maske folgt, oder
d) von einer beschleunigenden asymmetrischen EINZEL-Linse und einer verzögernden Immersionslinse, wobei die beschleunigende asymmetrische EINZEL-Linse auf die Maske folgt, oder
e) von einer asymmetrischen, beschleunigenden EINZEL-Linse und einer verzögernden asymmetrischen EINZEL-Linse, wobei die asymmetrische, beschleunigende EINZEL-Linse auf die Maske folgt.

## Beschreibung

Die Erfindung betrifft ein ionenoptisches Abbildungssystem, in dem eine auf einer Maske befindliche Struktur in Gestalt einer oder mehrerer Öffnungen über ein Linsensystem auf einen Wafer abgebildet wird, mit einer zwischen der Maske und dem Wafer angeordneten Kombination aus zwei Sammellinsen, wobei die Maske jeweils annähernd in der gegenstandsseitigen Brennebene der auf die Maske folgenden Sammellinse und der Wafer in der Umgebung der bildseitigen Brennebene der auf die Maske folgenden zweiten Sammellinse positioniert ist und bevorzugt die gegenstandsseitige Brennebene der zweiten auf die Maske folgenden Sammellinse den Cross-over der ersten auf die Maske folgenden Sammellinse enthält. Unter den verschiedenen Schritten, die zur Herstellung von Halbleiterbauelementen ausgeführt werden müssen, ist der Lithographieschritt besonders wichtig. Vereinfacht ausgedrückt, beginnt jeder Lithographieschritt mit dem Aufbringen einer dünnen Schicht aus lichtempfindlichem Material, dem sogenannten Photoresist oder kurz "Resist" auf einen Wafer, insbesondere aus Silizium. Ein Lithographiegerät projiziert dann die auf einer Maske vorhandene Struktur auf den mit dem Resist versehenen Wafer, wobei die Ausdehnung dieser projizierten Struktur auf dem Wafer meist sehr viel kleiner ist als der Wafer. Anschließend an die Projektion wird der Wafer verschoben und dieselbe Struktur der Maske auf eine andere Stelle des Wafers projiziert. Dieser Vorgang des Projizierens und Verschiebens wird solange wiederholt, bis die gesamte Waferfläche genutzt ist. Durch nachfolgende Entwicklung des Resists erhält man auf dem Wafer das gewünschte Muster in Form von resistfreien Stellen. Der Wafer kann dann in weiteren Schritten irgendeinem der bekannten Bearbeitungsvorgänge wie Ätzen, Ionenimplantation oder Aufbringen und Diffusion von Dotierungsmaterial unterzogen werden. Nach diesen weiteren Schritten wird der Wafer kontrolliert, wieder mit Resist überzogen und die gesamte vorerwähnte Schrittfolge etwa 8 - 15 mal wiederholt, bis schließlich eine schachbrettartige Anordnung von identischen Mikroschaltkreisen auf dem Wafer erzeugt ist.

Die meisten heute verwendeten Projektionslithographieverfahren verwenden Licht zur Bestrahlung des Resists, aber das Bedürfnis nach kleineren Strukturen und höherer Dichte der Komponenten der Mikroschaltkreise hat dazu geführt, intensiv nach anderen Bestrahlungsmethoden zu suchen, die in ihrer Auflösung nicht wie bei Anwendung von Licht auf dessen relativ große Wellenlänge beschränkt sind. Große Anstrengungen wurden unternommen, um Röntgenstrahlen in Lithographiegeräten zu verwenden, während andere Verfahren wie z.B. die Ionenlithographie, zwar einige, aber doch wesentlich weniger Beachtung erfahren haben.

Das Hauptziel der vorliegenden Erfindung ist es, ein ionenoptisches Abbildungssystem zu entwickeln, das die Beschränkungen und Nachteile der existierenden Systeme weitgehend vermeidet bzw. überwindet. Hiezu wird für ein Abbildungssystem der eingangs erwähnten Art vorgeschlagen, daß die Kombination aus zwei Sammellinsen von folgenden Linsenarten gebildet wird:
a) von zwei beschleunigenden EINZEL-Linsen,
b) von einer beschleunigenden und einer verzögernden Immersionslinse, wobei die beschleunigende Immersionslinse auf die Maske folgt, oder
c) von einer beschleunigenden Immersionslinse und einer asymmetrischen verzögernden EINZEL-Linse, wobei die beschleunigende Immersionslinse auf die Maske folgt, oder
d) von einer beschleunigenden asymmetrischen EINZEL-Linse und einer verzögernden Immersionslinse, wobei die beschleunigende asymmetrische EINZEL-Linse auf die Maske folgt, oder
e) von einer asymmetrischen, beschleunigenden EINZEL-Linse und einer verzögernden asymmetrischen EINZEL-Linse, wobei die asymmetrische, beschleunigende EINZEL-Linse auf die Maske folgt.

Unter einer Immersionslinse ist dabei eine Anordnung zu verstehen, die zwei koaxiale, rotationssymmetrische Elektroden (z. B. zwei koaxiale Rohre) aufweist, die sich auf verschiedenen Potentialen befinden. Werden die Ionen beim Übergang zwischen erster und zweiter Elektrode beschleunigt, handelt es sich um eine beschleunigende, im entgegengesetzten Fall um eine verzögernde Immersionslinse. Zum Abschluß bzw. zur Verkürzung der Linsen werden diese häufig mit Abschlußblenden versehen, die lediglich Öffnungen der notwendigen Größe für den Strahldurchgang besitzen.

Bei einer EINZEL-Linse handelt es sich um ein System von 3 koaxialen rotationssymmetrischen Elektroden, von denen sich die erste und dritte auf dem gleichen Potential und die Mittelelektrode auf einem davon verschiedenen Potential befindet. Werden die Ionen beim Eintritt in die Linse zunächst beschleunigt und anschließend in der zweiten Linsenhälfte wieder auf die ursprüngliche Energie abgebremst, spricht man von einer beschleunigenden EINZEL-Linse, im andern Fall von einer verzögernden EINZEL-Linse. Insgesamt ändert sich jedoch die Teilchenenergie beim Durchgang durch eine EINZEL-Linse nicht, da Anfang und Ende stets auf dem gleichen Potential liegen.

Unter asymmetrischer EINZEL-Linse ist eine Linse zu verstehen! bei der sich die drei Elektroden auf drei verschiedenen Potentialen befinden. In diesem Fall bewirkt der Durchgang der Teilchen durch die Linse wie bei Immersionslinsen eine Änderung der Teilchenenergie und in gleicher Weise wie bei Immersionslinsen spricht man von beschleunigenden oder verzögernden, jedoch asymmetrischen EINZEL-Linsen, wenn durch den Übergang von Potential der ersten Elektrode zum Potential der dritten Elektrode die Ionenenergie entweder vergrößert oder reduziert wird

Asymmetrische EINZEL-Linsen werden verwendet, weil sie erheblich kleinere Bildfehler besitzen als äquivalente Immersionslinsen, d.h. als Immersionslinsen mit gleicher Anfangs- und Endspannung und gleichem Elektrodendurchmesser.

Mit Hilfe jeder der erfindungsgemäßen Kombinationen zweier Sammellinsen wird ermöglicht, zur Bestrahlung des Resist sehr niederenergetische Ionen zu verwenden. Damit können bei wesentlich höherer Auflösung im Vergleich zu Licht Submikronstrukturen unter 0,25 µm realisiert werden und der Nachteil der hiezu ebenfalls möglichen Röntgenlithograhpie, nämlich die Erzeugung von Defekten im Siliziumsubstrat vermieden werden, weil Ionen der hier vorgeschlagenen niederen Energie ( 10 KeV) bereits im 0,5 µm starken Resist gestoppt werden können und daher das Substrat nicht erreichen können.

Das erfindungsgemäß ausgestaltete ionenoptische Abbildungssystem erlaubt sohin eine defektfreie Ionenlithographie, mit der die auf einer Maske befindliche Struktur verkleinert auf einen Wafer abgebildet werden kann und auch für große Bildfelder (∼20 x 20 mm²) eine nahezu verzeichnungsfreie (max. Verzeichnung < 0,2 µm) und scharfe (Bildunschärfe durch chromatische Fehler < 0,1 µm) Abbildung erhalten wird. Durch geeignete Wahl der Spannungen an den zur Abbildung verwendeten elektrostatischen Sammellinsen wird erreicht, daß die Ionenenergie am Wafer (E_{W}) etwa gleich groß ist wie die Ionenenergie an der Maske (E_{M}). Das Verhältnis E_{M}/E_{W} (Ionenenergie am Ort der Maske zu Ionenenergie am Ort des Wafers) kann dabei im Bereich 0,5 x 2 liegen. Damit ist es möglich, die Ionenenergie am Wafer auf ca. 5 - 10 KeV zu reduzieren. In diesem Fall werden die Ionen im dem Resist voll abgebremst und erreichen nicht mehr das Si-Substrat, sodaß sichergestellt ist, daß durch den Lithographieprozeß keinerlei Defekte im Substrat erzeugt werden. Die Tatsache, daß der Resist nicht voll durchstrahlt wird, ist dabei nicht schädlich, da es geeignete Entwicklungsverfahren für solche nur teildurchstrahlte Resists gibt. "Surface Imaging of Focused Ion Beam Exposed Resists" von M.A.Hartney und D.C. Shaver anläßlich des "35th International Symposios on Electron, Ion and Photon Beams" Seattle, Washington 28. - 31.5.1991.

Ferner zeichnet sich das erfindungsgemäße ionenoptische Abbildungssystem auch dadurch aus, daß die genannten Effekte in einer Ionenprojektionsanlage erzielt werden können, die in Räumen untergebracht werden können, wie sie derzeit für Ionenimplantationsanlagen üblich sind. In dem erfindungsgemäßen Abbildungssystem wird mit einem Abstand von bloß ca. 3 m zwischen Maske und Wafer das Auslangen gefunden, bei einer Gesamtlänge zwischen Ionenquelle und Wafer von ca. 6 m (20 x 20 mm² Bildfeldgröße).

Gegenüber allen bisherigen Ionenprojektionslithographiesystemen ermöglicht das erfindungsgemäße System erstmals die Verwendung sehr niedriger Ionenenergien am Wafer und erlaubt zusätzlich bei gegebener Maschinengröße die Verwendung erheblich größerer Bildfelder.

Für die Ausführungsform, in der zwei beschleunigende EINZEL-Linsen als Sammellinsen eingesetzt werden, ergibt sich exakt gleiche Ionenenergie an Maske und Wafer, womit diese beiden wichtigen Komponenten damit gleichzeitig an Erdpotential gelegt werden können, was bezüglich der an beiden Orten notwendigen Kontroll-, Meß- und Regeleinrichtungen zu wesentlichen Vereinfachungen und Kosteneinsparungen führt.

Hinsichtlich des Einsatzes einer beschleunigenden Immersionslinse als auf die Maske folgende Sammellinse und einer verzögernden Immersionslinse als vor dem Wafer angeordnete Linse, liegt eine konstruktiv besonders einfache Realisierung vor, da nur je zwei Elektroden pro Linse bereitgestellt werden müssen. Diese Anordnung ist besonders zur Realisierung von Systemen geeignet, bei denen die Ionenenergie auf dem Wafer kleiner als auf der Maske sein kann.

Die Kombination einer beschleunigenden Immersionslinse als auf die Maske folgende Linse und einer asymmetrischen, verzögernden EINZEL-Linse als vor dem Wafer angeordnete Linse oder die Kombination einer asymmetrischen beschleunigenden EINZEL-Linse als auf die Maske folgende Linse und einer verzögernden Immersionslinse als vor dem Wafer angeordnete Linse ergibt etwa im wesentlichen dieselben Ergebnisse wie die Anordnung zweier beschleunigender EINZEL-Linsen, zusätzlich kann jedoch dabei ein System realisiert werden, bei dem die Ionenenergie am Ort des Wafers kleiner ist als am Ort der Maske. Im allgemeinen wird bei dieser Linsenkombination aber bei vorgegebener Linsengeometrie die Realisierung eines Ionenprojektionslithographiesystems, das die eingangs angeführten Effekte erreichen läßt, nur für ein bestimmtes Verhältnis zwischen der Ionenenergie am Wafer und Ionenenergie auf der Maske möglich sein, da das System zu wenig frei wählbare Parameter (Linsenspannung) besitzt, um für beliebige Energieverhältnisse optimierbar zu sein.

Die erfindungsgemäße Ausführung, bei der eine asymmetrische, beschleunigende EINZEL-Linse als auf die Maske folgende Linse und eine asymmetrische, verzögernde EINZEL-Linse als vor dem Wafer angeordnete Linse eingesetzt werden, ist zwar mit dem höchsten Aufwand (vier verschiedene Linsenspannungen) verbunden, besitzt aber wegen der großen Zahl freier Parameter die größte Flexibilität, so daß diese Linsenkombination verwendet werden wird, wenn das System ein beliebig vorgegebenes Energieverhältnis zwischen der Ionenenergie an der Maske und der Ionenenergie am Wafer haben soll, das von eins verschieden ist.

Bei der praktischen Realisierung des erfindungsgemäßen Ionenprojektionslithographiesystems wird die "Beleuchtung" der Maske nicht unmittelbar durch die Ionenquelle ausgeführt, sondern durch ein vorgeschaltetes Beleuchtungssystem erfolgen, um die Lage des für die Beleuchtung der Maske maßgeblichen virtuellen Quellpunktes beliebig variieren zu können und hiebei den Abstand zwischen der körperlichen, realen Ionenquelle und der Maske von nicht größer als etwa 3 - 4 m einzuhalten, was aus konstruktiven Gründen angestrebt wird. Für den virtuellen Quellpunkt sind aber aus zwei Gründen wesentlich größere Distanzen erforderlich. Zunächst ist zur Erzielung optimaler Verzeichnungsfreiheit (s. die Ausführungsbeispiele) ein annähernd paralleler Strahlauffall auf die Maske notwendig, was Abstände zwischen der virtuellen Ionenquelle und Maske von einigen 10 m erfordert, und weiters ist wegen der aus Stabilitätsgründen notwendigen Maskenstärke von einigen µm es erforderlich, daß die Ionen nahezu senkrecht auf die Maske auftreffen. Hieraus ergibt sich eine Beschränkung des Auftreffwinkels der Ionen auf die Maske auf etwa 0,1°, um kleine Strukturen (z.B. 5 µm breite Schlitze) auf der Maske ohne merkliche Abschattung auf den Wafer zu projizieren. Auch dies führt bei einer vorgesehenen Maskengröße von 60 x 60 mm² zu einem ähnlichen Mindestabstand der virtuellen Ionenquelle von der Maske.

Ferner ist zu beachten, daß jede Ionenquelle außer den erwünschten Ionen noch eine Reihe unerwünschter Ionensorten emittiert, für deren Ausblendung vor dem Wafer zu sorgen ist. Um die vorerwähnten Auflagen zu erreichen, wird für eine Beleuchtungseinrichtung für die Maske in einem ionenoptischen Abbildungssystem, das insbesondere für den Einsatz in einem ionenoptischen Abbildungssystem erfindungsgemäßer Ausgestaltung vorgesehen ist und das mit einer Ionenquelle, einer gegebenenfalls von einer (beschleunigenden oder verzögernden) EINZEL-Linse gebildeten sogenannten Ionenquellenlinse sowie einem der Ionenquellenlinse folgenden, insbesondere als ExB-Filter ausgebildeten Massenseparator versehen ist, erfindungsgemäß vorgeschlagen, daß dem Massenseparator eine sogenannte Beleuchtungslinse folgt, welche alternativ als Immersionslinse oder als beschleunigende oder als verzögernde EINZEL-Linse ausgebildet oder von einem bzw. auch mehreren Solenoiden gebildet ist. Bei diesem Abbildungssystem wird durch die Ionenquellenlinse kurzer Brennweite die Ionenquelle in das Zentrum des Massenseparators eines Wien-Filters (ExB Filter), d.i. eine Anordnung , in der ein homogenes elektrisches Feld einem dazu senkrechten homogenen Magnetfeld überlagert wird, abgebildet. Für Ionen der gewünschten Masse heben sich die von den beiden Feldern erzeugten Kräfte exakt auf, bei allen anderen Ionen ist dies nicht der Fall, und sie werden durch Ablenkung aus dem Strahl entfernt. Anschließend erzeugt die Beleuchtungslinse ein virtuelles Bild der Ionenquelle, mit dem Abstände der virtuellen Ionenquelle von der Maske realisiert werden können, die im Bereich von einigen 10 bis einigen 100 m liegen können.

Dabei muß die Beleuchtungslinse eine ähnlich hohe Qualität haben wie die beiden Sammellinsen, da ihre Verzeichnung im Zusammenwirken mit der Verzeichnung der Abbildungslinsen zu zusätzlichen Verzeichnungen 5. Ordnung führt, die die Gesamnerzeichnung wesentlich verschlechtern kann. Als Beleuchtungslinse ist dabei die Verwendung einer elektrostatischen EINZEL-Linse von etwa Dimension und Qualität der Abbildungslinsen besonders bevorzugt.

Die Erfindung wird nachstehend anhand der Zeichnung beispielsweise näher erläutert, in welcher weitere für die Erfindung wesentliche Details dargestellt sind. Es zeigen,
Fig. 1 schematisch den Strahlengang in einem Ionenstrahlprojektionslithographiesystem mit zwei Sammellinsen,
Fig. 2 ein System analog Fig. 1, wobei in vollen Linien der Strahlengang für ideale, verzeichnungsfreie Linsen und in unterbrochenen Linien der Strahlengang unter Berücksichtigung der Verzeichnung dargestellt ist,
Fig. 3 ein System analog Fig. 1, in welchem in vollen Linien der Strahlengang eingetragen ist, wie er bei Sollenergie E₀ auftritt, mit unterbrochenen Linien, hingegen der Strahlengang bei von der Sollenergie um ΔE₀ abweichender (verminderter) Energie, zur Veranschaulichung der Korrektur des chromatischen Bildfehlers,
Fig. 4 eine Beleuchtungseinrichtung in schematischer Darstellung, wie sie für alle erfindungsgemäßen Kombinationen, die von zwei Sammellinsen Gebrauch machen, eingesetzt werden kann,
Fig. 5 in einem axialen Längsschnitt ein Ausführungsbeispiel einer EINZEL-Linse , mit eingetragenen Potentiallinien, für ein Beleuchtungssystem gemäß Fig. 4,
Fig. 6 in einem axialen Längsschnitt ein Ausführungsbeispiel eines erfindungsgemäßen Abbildungssystems, in dem eine Sammellinse als beschleunigende Immersionslinse und die zweite Sammellinse als verzögernde Immersionslinse ausgebildet ist, mit dem zugehörigen Potentiallinienverlauf,
Fig. 7 ebenfalls in einem axialen Längsschnitt, eine verzögernde, asymmetrische EINZEL-Linse mit eingezeichneten Potentiallinien, wobei diese Linse zusammen mit einer beschleunigenden Immersionslinse als Sammellinse Verwendung finden kann,
Fig. 8 schematisch die Lage der Startpunkte von Ionen auf der Maske, deren Bewegung durch das System aus zwei Sammellinsen untersucht wurde,
Fig. 9a schematisch den Aufbau einer Immersionslinse von rotationssymmetrischer Gestaltung, und
Fig. 9b schematisch den grundsätzlichen Aufbau einer EINZEL-Linse in axialem Längsschnitt, ebenfalls in Ausbildung als Rotationskörper.

In der Zeichnung ist mit M eine Maske bezeichnet, welche die abzubildende Struktur aufweist, die auf einen Wafer W abgebildet wird.

Die Maske M, welche die abzubildende Struktur in Form von Öffnungen in einer Folie (z.B. aus Silizium) aufweist, wird von einer Ionenquelle Q mit sehr geringer virtueller Quellengröße (∼10 µm) beleuchtet und befindet sich annähernd in der Brennebene einer ersten Sammellinse L1. Diese Sammellinse L1 erzeugt einen Crossover (reelles Bild der Ionenquelle Q) an der Stelle C, kurz hinter ihrem bildseitigen Brennpunkt, sofern der Abstand zwischen der Ionenquelle Q und der auf die Maske M folgenden Sammellinse L1 groß ist gegenüber der Brennweite dieser Sammellinse L1. Der gegenstandsseitige Brennpunkt der vor dem Wafer W angeordneten zweiten Sammellinse L2 befindet sich am Ort des Cross-over C. Damit verlassen die Strahlen die Sammellinse L2 sämtlich achsparallel und man erhält ein annähernd telezentrisches System. Dieses hat den Vorteil, daß sich der Abbildungsmaßstab bei kleinen Verschiebungen des Wafers W in Richtung der ionenoptischen Achse nicht ändert.

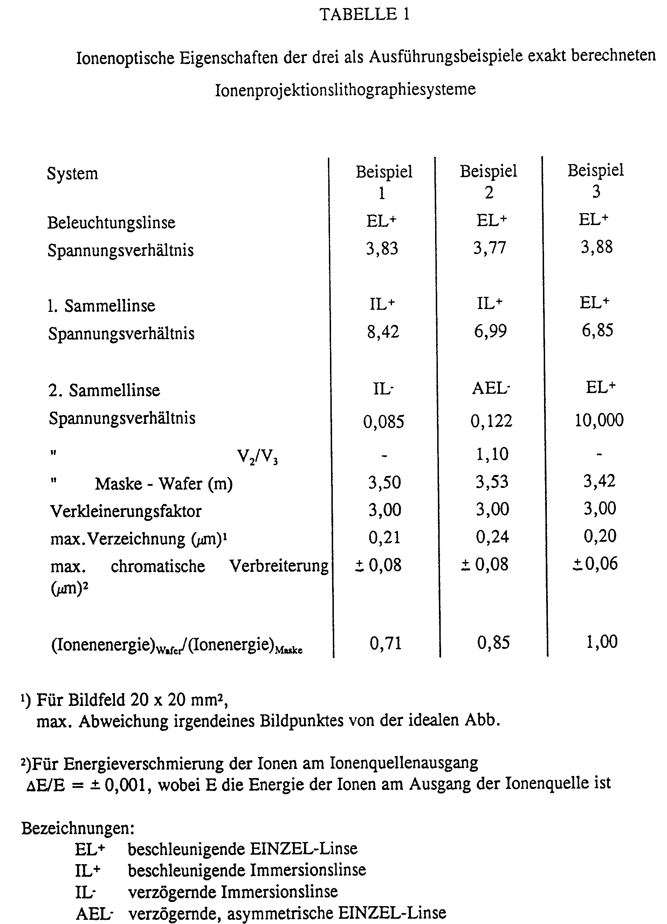

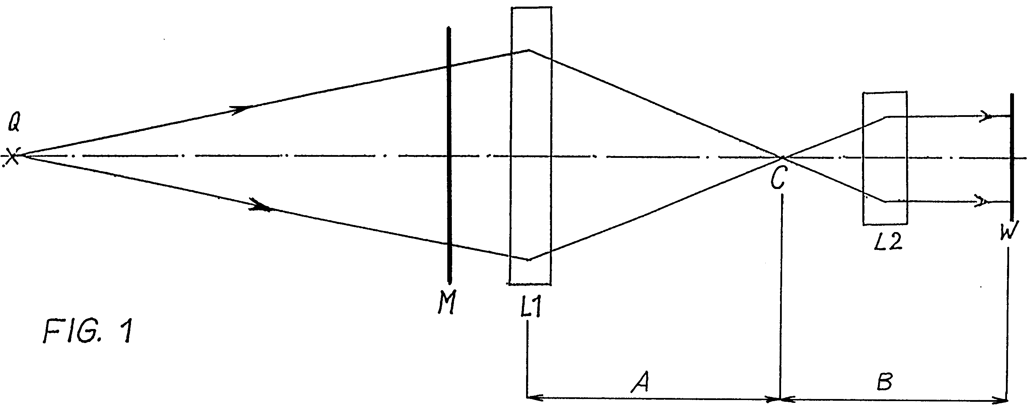

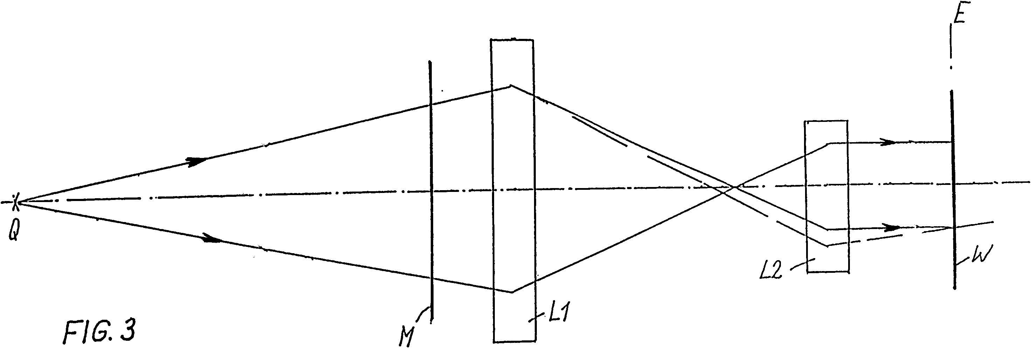

Dieses System besitzt (unabhängig von der noch zu betrachtenden Realisierung der Sammellinsen L1 und L2 als EINZEL-, Immersions- oder asymmetrische EINZEL-Linse) die folgenden Eigenschaften:
a) Das die Strukturen der Maske auflösende Bildfeld wird durch die Kombination der beiden Sammellinsen L1 - L2 in der Umgebung des bildseitigen Brennpunktes der vor dem Wafer W angeordneten Sammellinse L2 abgebildet, wenn sie sich, wie vorgesehen, in der Umgebung des gegenstandsseitigen Brennpunktes der auf die Maske M folgenden Sammellinse L1 befindet.
b) Das Strahlenbündel erhält durch die auf die Maske M folgende Sammellinse L1 einen tonnenförmige Verzeichnung (Bereich A) in F, die nach dem Cross-over C in eine kissenförmige Verzeichnung übergeht (Bereich B).

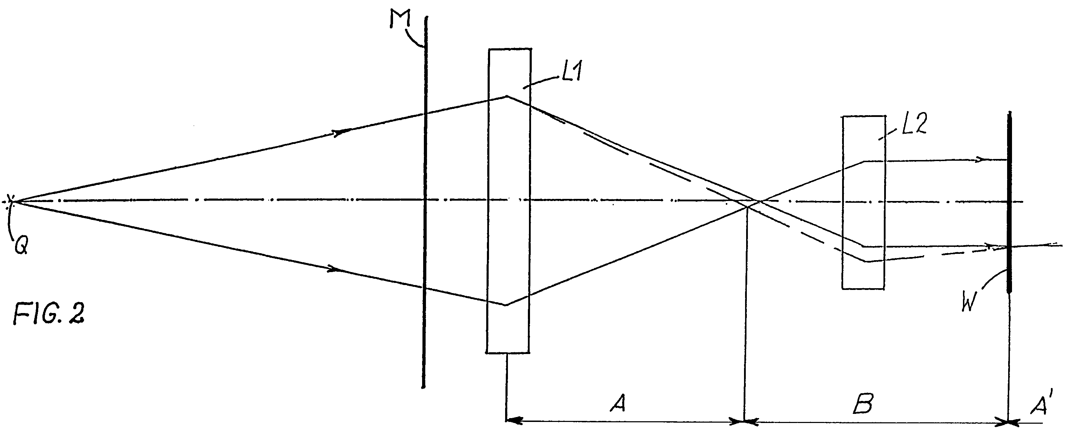

   Fig. 2 veranschaulicht nun, daß durch die Verzeichnung der vor dem Wafer W angeordneten Sammellinse L2 die Strahlen eine zusätzliche Ablenkung erhalten, die diese kissenförmige Verzeichnung (Bereich B) reduziert und wieder in eine tonnenförmige Verzeichnung (Bereich A′) überführt. Dabei gibt es hinter der vor dem Wafer W angeordneten Sammellinse L2 eine Ebene, in der sich die durch beide Sammellinsen L1 und L2 hervorgerufenen Verzeichnungen kompensieren. Dies gilt allerdings nur für den Verzeichnungsfehler dritter Ordnung, es bleibt der (sehr viel kleinere) Verzeichnungsfehler 5. Ordnung, d. h. die Verzeichnung verschwindet nicht zur Gänze, sondern besitzt lediglich ein ausgeprägtes Minimum. Bei vorgegebener Bildfeldgröße ist diese Restverzeichnung umgekehrt proportional zur fünften Potenz des Abstandes Maske - Wafer bei gleichmäßiger Änderung aller Dimensionen im optischen System zwischen Maske und Wafer.
c) In der Anordnung nach Fig. 1 ergibt sich (wie in Fig. 3 ersichtlich gemacht) auch für den chromatischen Fehler eine Kompensation der Wirkungen der bei den Sammellinsen L1 und L2 für eine bestimmte Bildebene hinter der vor dem Wafer W angeordneten Sammellinse L2. Ein Strahl (in Fig. 3 in unterbrochenem Linienzug dargestellt) mit etwas kleiner Energie E₀ - ΔE₀ als der Sollenergie E₀ wird in der auf die Maske M folgenden ersten Sammellinse L1 stärker abgelenkt, trifft infolgedessen die vor dem Wafer W angeordnete zweite Linse L2 in größerer Achsenfeme als der (in vollem Linienzug dargestellte) Sollstrahl und wird daher aus diesem Grund und wegen seiner geringeren Energie um sovielmehr zurückgelenkt, daß er in einer bestimmten Entfernung hinter der vor dem Wafer W angeordneten Sammellinse L2 den Sollstrahl trifft. In dieser Ebene E verschwindet offensichtlich der chromatische Fehler erster Ordnung. Es verbleibt auch hier ein Restfehler, der chromatische Fehler 2. Ordnung, d.h. ein Fehler proportional zum Quadrat der Energieabweichung vom Sollstrahl.
d) Die drei relevanten Ebenen, die Gaußsche Bildebene der Maske M, die Ebene minimaler Verzeichnung und die Ebene E minimalen chromatischen Fehlers werden im allgemeinen nicht zusammenfallen. Durch geeignete Wahl der Sammellinsen L1 und L2 und der Ionenquellenlage kann jedoch erreicht werden, daß unter Beibehaltung des parallelen Strahlenganges die genannten drei Ebenen zusammenfallen. Wird der Wafer W dort angeordnet, wo die drei Ebenen zusammenfallen, so bewirkt dies, daß in der Bildebene der Maske (d.i. der Ort des Wafers W) sowohl ein Minimum der Verzeichnung als auch ein Minimum des chromatischen Fehlers vorhanden ist.
e) Der Abbildungsmaßstab, d.h. der Verkleinerungsfaktor, mit dem die Struktur der Maske auf den Wafer W abgebildet wird, ist annähernd gegeben durch das Verhältnis der bildseitigen Brennweite der auf die Maske M folgenden ersten Sammellinse L1 zur gegenstandsseitigen Brennweite der vor dem Wafer W angeordneten zweiten Sammellinse L2. Durch Skalierung (ähnliche Vergrößerung oder Verkleinerung von L2) ist es daher möglich, den Verkleinerungsfaktor des Abbildungssystems unter Beibehaltung aller übrigen Eigenschaften (gleichzeitige Korrektur von Verzeichnung und des chromatischen Fehlers am Gaußschen Bildpunkt der Maske) zu verändern.

Zur praktischen Realisierung eines solchen Systems von zwei Sammellinsen können verschiedenartige elektrostatische Linsen verwendet werden, nämlich
1) beschleunigende oder verzögernde Immersionslinsen,
2) beschleunigende oder verzögernde EINZEL-Linsen,
3) beschleunigende oder verzögernde asymmetrische EINZEL-Linsen.

Für die praktische Realisierung des erfindungsgemäßen ionenoptischen Abbildungssystems sind die folgenden erfindungsgemäßen Kombinationen für die Sammellinsen L1 und L2 vorgesehen:
aa) beschleunigende EINZEL-Linse - beschleunigende EINZEL-Linse
bb) beschleunigende Immersionslinse - verzögernde Immersionslinse
cc) beschleunigende Immersionslinse - verzögernde asymmetrische EINZEL-Linse
dd) beschleunigende asymmetrische EINZEL-Linse - verzögernde Immersionslinse
ee) beschleunigende asymmetrische EINZEL-Linse - verzögernde asymmetrische EINZEL-Linse.

In Fig. 9a ist eine Immersionslinse in axialem Längsschnitt dargestellt, die durch zwei koaxial zueinander angeordnete, rotationssymmetrische Elektroden 1, 2 gebildet ist, wobei diese Elektroden in eine Hülse 3 aus isolierendem Material eingebaut sind. Jede der Elektroden 1, 2 besitzt einen Boden 4 bzw. 5, der in der optischen Achse jeweils mit einem Loch 6 bzw. 7 für den Ein- bzw. Austritt der Ionen versehen ist. Die Elektroden 1 und 2 sind an verschiedene Spannungen V1 bzw. V2 angelegt. Werden in der Linse die Ionen beschleunigt, so liegt eine beschleunigende Immersionslinse vor. Werden die Ionen verzögert, spricht man von einer verzögernden Immersionslinse.

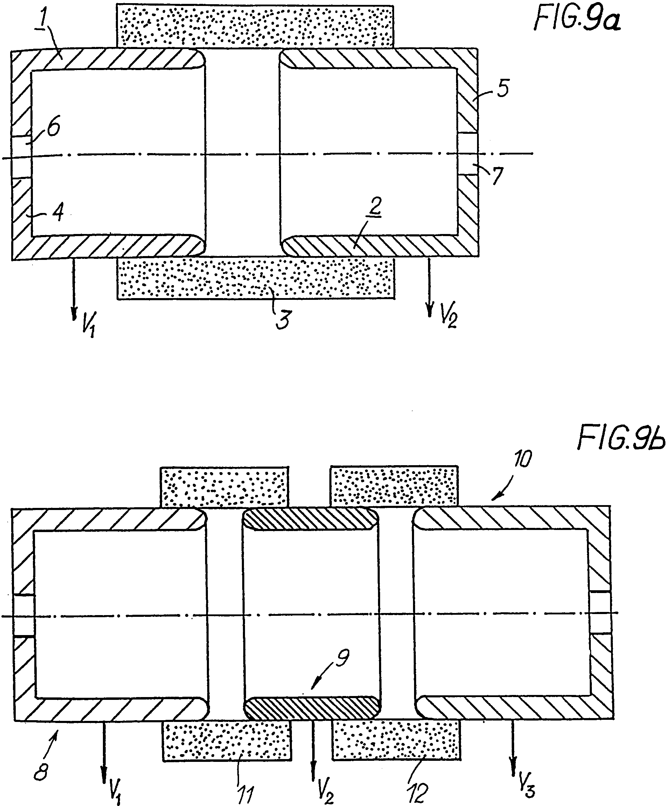

Fig. 9b zeigt den grundsätzlichen Aufbau einer EINZEL-Linse. Eine solche Linse besitzt drei Elektroden 8, 9 und 10, die voneinander durch Hülsen 11 und 12 aus isolierendem Material getrennt sind. Bei einer " normalen " EINZEL-Linse liegt dieElektrode 9 auf einem Potential, das unterschiedlich von den Potentialen V1 und V3 der endstündigen Elektroden 8 und 1O ist. Sind die Potentiale V1 und V3 gleich und werdne die Ionen unter dem Einfluß des Potentials V2 der mittleren Elektrode 9 beschleunigt, wird von einer beschleunigenden EINZEL-Linse (EL⁺) gesprochen, andernfalls spricht man von einer verzögernden EINZEL-Linse (EL⁻). Sind die Potentiale V1 und V3 der endständigen Elektroden 8 und 10 voneinander verschieden, handelt es sich um eine asymmetrische EINZEL-Linse. Auch bei einer solchen asymmetrischen EINZEL-Linse können abhängig vom Potential an der mittleren Elektrode die Ionen beim Durchgang durch die Linse beschleunigt oder verzögert werden. Solche Linsen werden dann als asymmetrische, beschleunigende EINZEL-Linsen (AEL⁺) bzw. asymmetrische, verzögernde EINZEl-Linsen (AEL⁻) bezeichnet.

Beispiele:
Für drei Fälle von unterschiedlichen Kombinationen von Paaren von Sammellinsen wurden die Abbildungseigenschaften der Ionenprojektionslithographiesysteme numerisch überprüft, wobei als
Fall 1 eine Kombination aus beschleunigender elektrostatischer Immersionslinse und verzögernder elektrostatischer Immersionslinse mit einer elektrostatischen beschleunigenden EINZEL-Linse als Beleuchtungslinse, als
Fall 2 eine Kombination aus beschleunigender elektrostatischer Immersionslinse und verzögernder asymmetrischer elektrostatischer EINZEL-Linse mit einer elektrostatischen beschleunigenden EINZEL-Linse als Beleuchtungslinse und als
Fall 3 eine Kombination aus zwei elektrostatischen EINZEL-Linsen mit einer weiteren elektrostatischen beschleunigenden EINZEL-Linse als Beleuchtungslinse rechnerisch überprüft wurde.

Für alle diese Linsenkombinationen wurde dabei die Abbildung einer Maske mit einem die Strukturen aufweisenden Bildfehld von 60 x 60 mm² mit einem Verkleinerungsfaktor, somit auf eine Waferfläche von 20 x 20 mm² untersucht.

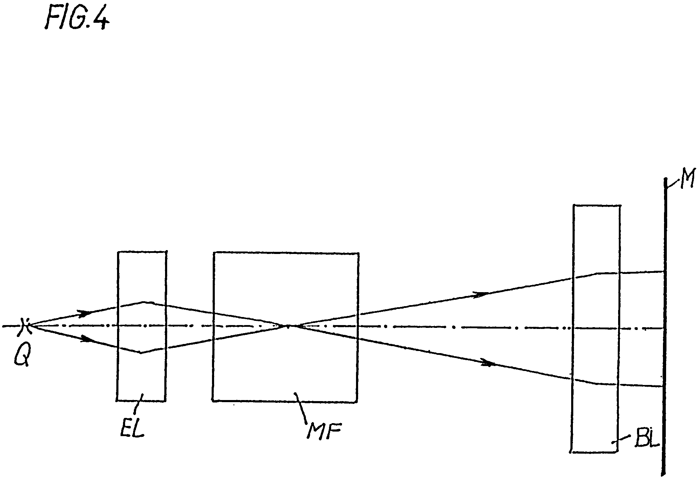

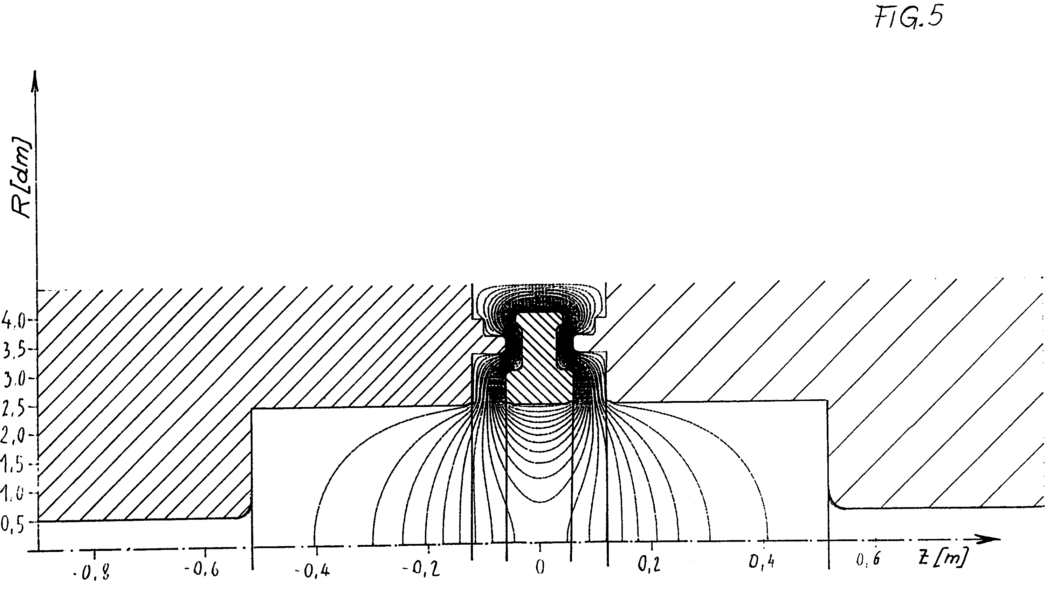

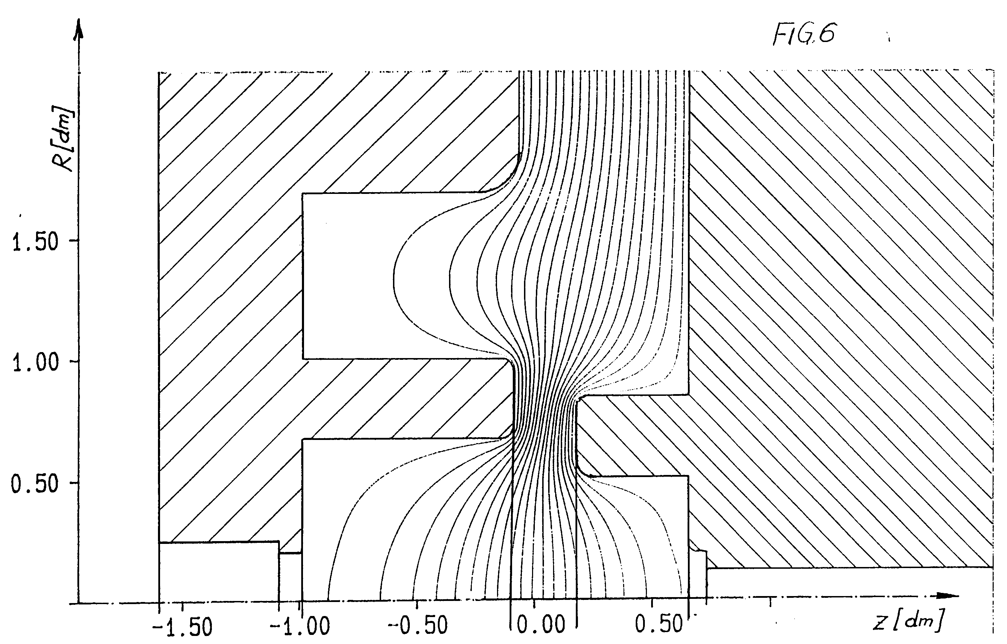

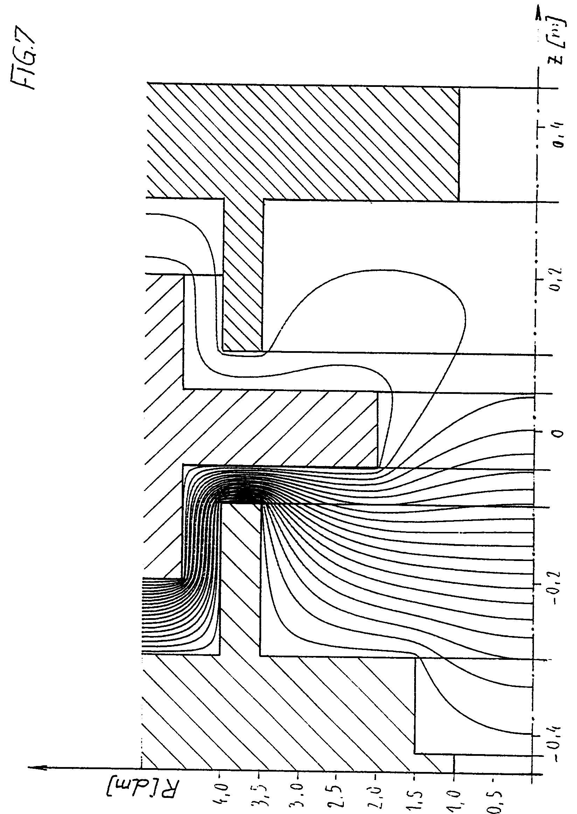

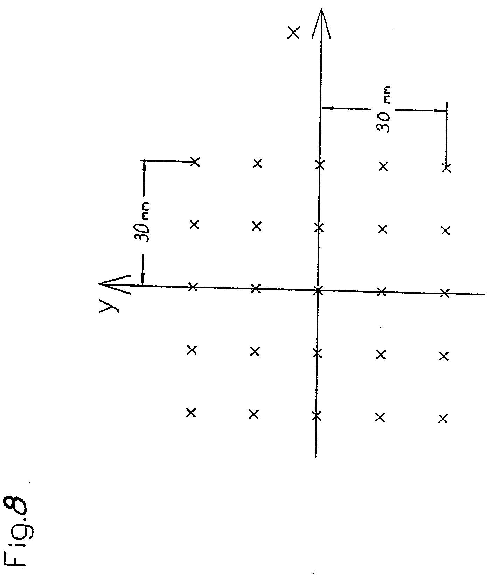

Die numerischen Ermittlungen wurden hiebei in folgenden Schritten durchgeführt:
1) Berechnung der Potentialverteilung bei gegebener Linsengeometrie aus der Potentialgleichung für die beiden zu kombinierenden Linsen. Für Immersionslinsen und EINZEL-Linsen genügte dazu ein Berechnungsvorgang. Bei asymmetrischen EINZEL-Linsen mußten die Berechnungen für eine Reihe von unterschiedlichen Spannungen an den beiden endständigen Elektroden durchgeführt werden. Die Fig. 5 - 7 zeigen Beispiele für den rechnerisch ermittelten Potentialverlauf der verwendeten Linsen.
2) Berechnung der Linsenparameter erster und dritter Ordnung als Funktion des Spannungsverhältnisses zwischen den Elektrodne der Linse (bzw. im Falle von asymmetrischen EINZEL-Linsen der beiden Spannungsverhältnisse). Dies geschah folgendermaßen:
   Zunächst wurde aus den aus der Potentialgleichung berechneten Potentialwerten das elektrische Feld bestimmt, wobei sich zeigte, daß zur Erzielung ausreichender Genauigkeit eine zweidimensionale kubische Interpolation notwendig war. Dann wurde eine Anzahl von Teilchenbahnen durch die Linse (gleichmäßig verteilt über den interessanten Ausleuchtungsbereich der Linsen) durch numerische Integration verfolgt. Aus den Positionen der Bahnen am Linsenende kann dann die Transfermatrix in erster, dritter und fünfter Ordnung bestimmt werden. Berechnungen dieser Art mit verschiedenen Einschußenergien der Ionen ergeben die Transfermatrix für verschiedene Spannungsverhältnisse. Als Ergbnis dieser Folge von Rechnungen wird für die untersuchten Linsen die Transfermatrix in fünfter Ordnung als Funktion des Spannungsverhältnisses (bzw. der beiden Spannungsverhältnisse bei asymmetrischen EINZEL-Linsen) erhalten.
3) Nach der Standardmethode der Matrizenmultiplikation wird der Strahlengang durch Systeme, bestehend aus zwei Linsen und Driftstrecken, von einem gegebenen Anfangsort (Maske) zu einem gegebenen Endort (Wafer) und damit die Transfermatrix berechnet (siehe Fig. 1). Dabei werden die Matrizen für die Linsen als Funktion des Spannungsverhältnisses an den Elektroden aus den Ergebnissen von Schritt 2) übernommen.
   Aus den ermittelten Transfermatrizen können die Bildorte für eine Reihe von Startpunkten aus der Maske errechnet werden, wobei in den Rechnungen stets die aus Fig. 8 ersichtliche Anordnung der Startpunkte gewählt wurde. Die Richtung der von diesen Startpunkten ausgehenden Strahlen ist dabei durch die angenommene Lage der Ionenquelle sowie die Labe und Stärke der Beleuchtungslinse bestimmt (s. Fig. 4) und kann ebenfalls berechnet werden. Aus der Lage der Bildpunkte können dann durch einen linearen Fit mittlere und maximale Werte der Verzeichnung aus den Abweichungen der berechneten Bildorte von den entsprechenden Fitgeraden ermittelt werden. Weiterhin werden solche Bildortberechnungen auch für Energien durchgeführt, die sich um einen kleinen Betrag (ΔE) von der gewählten Sollenergie (E) unterscheiden, woraus dann die Werte für den chromatischen Fehler des Linsensystems bestimmt werden können.
4) Das erfindungsgemäße Abbildungssystem (die Kombination der beiden Sammellinsen) kann hinsichtlich der Bildfehler optimiert werden. Durch Iteration kann eine Optimierung bezüglich gleichzeitiger Minimierung von Verzeichnung und chromatischen Fehlern vorgenommen und dabei auf Wunsch noch eine Reihe von Nebenbedingungen erfüllt werden.

Bei den hier erwähnten Ausführungsbeispielen wurde dabei wie folgt vorgegangen:
1) Nebenbedingungen, die zu erfüllen waren:
   1.a) Paralleler Strahlengang des Abbildungssystems (d.i. vor dem Wafer nach der dem Wafer vorgelagerten Sammellinse).
   1.b) Gaußsche Abbildung der Maske M auf den Wafer W.
   1.c) Abbildungsmaßstab Maske - Wafer (meist 1/3).
2) Folgende Größen waren (unter Einzahlung der vorgenannten Nebenbedingungen) zum Zwecke der Bildfehlerminimierung variiert:
   2.a) Abstand zwischen Maske M und der auf diese folgenden Linse L1,
   2.b) Abstand zwischen den beiden Sammellinsen L1 und L2
   2.c) Abstand zwischen dem Wafer W und der dem Wafer W vorgelagerten Sammellinse L2 und
   2. d) Skalierungsfaktor, d. h. ähnliche Vergrößerung bzw. Verkleinerung durch die dem Wafer W vorgelagerte Sammellinse L2.
3) Zur weiteren Optimierung wurden die Spannungsverhältnisse zwischen den Elektroden der beiden Sammellinsen L1 und L2 variiert.

Die Ergebnisse dieser Berechnungen sind in Tabelle 1 zusammengestellt. Sie lassen sich folgendermaßen zusammenfassen:
1) Mit allen 3 Linsenkombinationen läßt sich das 60 x 60 mm² große Bildfeld der Maske M auf 1/3 verkleinert auf den Wafer W abbilden, wobei am Ort des Wafers W (dem Bildort) gleichzeitig ein Minimum der Verzeichnung (max. Verzeichnung < 0,2 µm) und der Bildunschärfe (< 0,1 µm) erreicht werden kann.
2) In allen Fällen ist dazu eine Maschinenlänge (Abstand zwischen Maske M und Wafer W) von ca. 3,5 m notwendig, die drei untersuchten Linsenkombinationen sind im wesentlichen gleichwertig.
3) In den untersuchten Fällen konnten Energieverhältnisse zwischen der Ionenenergie am Wafer W und der Ionenenergie an der Maske M im Bereich von etwa 0,7 - 1,0 realisiert werden.
4) Für den Fall der Kombination von zwei asymmetrischen EINZEL-Linsen, von welchen die auf die Maske M folgende als beschleunigende, die zweite als verzögernde Linse arbeitet, wird eine ähnliche qualität erreicht werden, da im Vergleich zu den drei in der Tabelle aufgelisteten Fällen ein weiterer freier Parameter (ein zusätzliches Spannungsverhältnis) zur Optimierung des Gesamtsystems zur Verfügung steht.

Durch die Ausführungsbeispiele wird also gezeigt, daß ein erfindungsgemäßes Projektionslithographiesystem für geringe Ionenenergien sowie geringe Verzeichnung, hohe Aufladung und Telezentrizität am Wafer W mit allen vorgeschlagenen Linsenkombinationen erreicht werden kann.

Soferne als Maske eine solche mit nur einer Apertur verwendet wird, können mit den erfindungsgemäßen Linsenkombinationen Systeme aufgebaut werden, die einen Einzelstrahl niedriger Energie bei hoher Auflösung liefern, mit dem Reparaturen an Masken und Chips bzw. Modifikationen an Chips und Msken vorgenommen werden können.

## Patentansprüche

1. Ionenoptisches Abbildungssystem, in dem eine auf einer Maske befindliche Struktur in Gestalt einer oder mehrerer Öffnungen über ein Linsensystem auf einen Wafer abgebildet wird, mit einer zwischen der Maske und dem Wafer angeordneten Kombination aus zwei Sammellinsen, wobei die Maske jeweils annähernd in der gegenstandsseitigen Brennebene der auf die Maske folgenden Sammellinse und der Wafer in der Umgebung der bildseitigen Brennebene der auf die Maske folgenden zweiten Sammellinse positioniert ist und bevorzugt die gegenstandsseitige Brennebene der zweiten auf die Maske folgenden Sammellinse den Crossover der ersten auf die Maske folgenden Sammellinse enthält, dadurch gekennzeichnet, daß die Kombination aus zwei Sammellinsen von folgenden Linsenarten gebildet wird:
a) von zwei beschleunigenden EINZEL-Linsen,
b) von einer beschleunigenden und einer verzögernden Immersionslinse, wobei die beschleunigende Immersionslinse auf die Maske folgt, oder
c) von einer beschleunigenden Immersionslinse und einer asymmetrischen verzögernden EINZEL-Linse, wobei die beschleunigende Immersionslinse auf die Maske folgt, oder
d) von einer beschleunigenden asymmetrischen EINZEL-Linse und einer verzögernden Immersionslinse, wobei die beschleunigende asymmetrische EINZEL-Linse auf die Maske folgt, oder
e) von einer asymmetrischen, beschleunigenden EINZEL-Linse und einer verzögernden asymmetrischen EINZEL-Linse, wobei die asymmetrische, beschleunigende EINZEL-Linse auf die Maske folgt.

2. Beleuchtungseinrichtung für die Maske in einem ionenoptischen Abbildungssystem, insbesondere nach Anspruch 1, mit einer Ionenquelle, einer gegebenenfalls von einer EINZEL-Linse gebildeten sogenannten Ionenquellenlinse sowie einem der Ionenquellenlinse folgenden, insbesondere als ExB-Filter ausgebildeten Massenseparator, dadurch gekennzeichnet, daß dem Massenseparator eine sogenannte Beleuchtungslinse folgt, welche alternativ als Immersionslinse oder als beschleunigende oder als verzögernde EINZEL-Linse ausgebildet oder von einem oder mehreren Solenoiden gebildet ist.
